# DEMANDE DE BREVET EUROPEEN

(11) **EP 2 278 712 A1**
(43) Date de publication de la demande: **26.01.2011**
(21) Numéro de dépôt: 10006325.4
(22) Date de dépôt: 18.06.2010
(51) Int. Cl.: H03K 17/10, H03K 19/0185

(54) **Circuit intégré comprenant un circuit tampon haute tension large bande**

(30) Priorité: 01.07.2009 FR 0903230
(71) Demandeur: STMicroelectronics (Rousset) SAS, 13790 Rousset (FR)
(72) Inventeur: Demange, Nicolas, 83470 Saint Maximin La Sainte Baume (FR)
(74) Mandataire: Marchand, André

(57) **Abrégé**

L'invention concerne un circuit intégré (IC1) comprenant un circuit tampon de données (BUF1) comprenant des premier et second transistors (T11, T21) connectés à un plage de contact et des troisième et quatrième transistors (T12, T22). Une première tension de polarisation (V1) est appliquée sur une borne de conduction du troisième transistor (T12) et une deuxième tension de polarisation (V2) est appliquée sur une borne de conduction du quatrième transistor (T22). Une troisième tension de polarisation (V3) inférieure à la deuxième tension de polarisation (V2) est appliquée sur une borne de contrôle (G) du premier transistor (T11) et une quatrième tension de polarisation (V4) supérieure à la première tension de polarisation (V1) est appliquée sur une borne de contrôle du second transistor (T21). Application notamment à la réalisation d'un port USB dit "High Speed".

## Description

La présente invention concerne la réalisation d'un circuit intégré sur plaquette de semi-conducteur, comprenant un circuit tampon de données ("data buffer circuit") connecté à une plage de contact.

La présente invention concerne notamment la réalisation d'un circuit tampon de données qui soit à la fois compatible avec les spécifications USB "High Speed" et les spécifications USB "Full Speed" ("Universal Serial Bus").

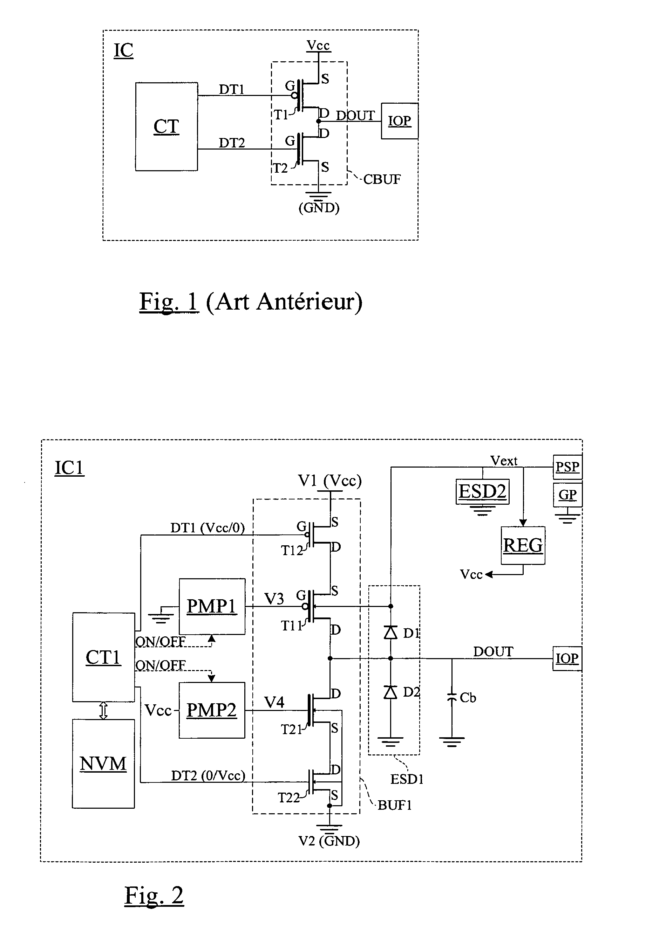

La figure 1 représente un circuit intégré IC comprenant un circuit tampon de données classique CBUF et une plage de contact IOP ("I/O Pad"). Le circuit tampon CBUF comprend deux transistors T1, T2 de technologie MOS ("Métal Oxyde Semi-conducteur"). Le transistor T1 est de type PMOS et le transistor T2 de type NMOS. Le transistor T1 reçoit sur sa source (S) une tension Vcc. Le drain (D) du transistor T1 est connecté au drain (D) du transistor T2, dont la source est reliée à la masse (GND). Les drains (D) des transistors T1, T2 sont connectés à la plage IOP. La grille (G) du transistor T1 reçoit un signal de données DT1 (i.e. un signal porteur de données) et la grille du transistor T2 reçoit un signal de données DT2, les signaux DT1, DT2 étant fournis par un circuit CT.

Le tableau 1 ci-après décrit le fonctionnement du circuit tampon CBUF. Le circuit tampon fonctionne en inverseur et fournit à la plage IOP un signal DOUT qui est l'inverse des signaux DT1, DT2. Les signaux DT1, DT2 sont identiques lors d'une transmission de données, et peuvent donc être considérés comme un seul et même signal de données. En dehors des périodes de transmission de données, ils sont respectivement mis à 1 et à 0 pour placer le circuit tampon dans un état de haute impédance (transistors T1, T2 bloqués).

**Tableau 1**

| **DT1 (T1)** | **DT2 (T2)** | **DOUT** |
|---|---|---|
| 0 (GND) | 0 (GND) | 1 (Vcc) |
| 1 (Vcc) | 1 (Vcc) | 0 (GND) |
| 1 (Vcc) | 0 (GND) | HZ (haute impédance) |

Les caractéristiques électriques du circuit tampon CBUF sont en pratique étroitement dépendantes de celles des transistors T1, T2 qui le composent. Lors de la conception du circuit intégré, un cahier des charges définit les performances visées en termes de tenue en tension (tension continue maximale que le circuit tampon doit être capable de supporter), de bande passante (fréquence maximale des signaux de données que le circuit tampon doit être capable de transmettre), et de résistance aux décharges électrostatiques (tension de décharge maximale que le circuit tampon doit être capable de supporter).

Pour réaliser des circuits intégrés à faible prix de revient ("low cost"), les designers essayent préférentiellement de réaliser un tel circuit tampon avec les transistors qui sont à leur disposition, à savoir les transistors utilisés pour réaliser le reste du circuit intégré. Dans le cas d'un circuit intégré comportant une mémoire non volatile, par exemple une mémoire programmable et effaçable électriquement de type EEPROM ou Flash-EEPROM, les concepteurs disposent de deux types de transistors :
- des transistors haute tension à oxyde épais, utilisés pour réaliser la mémoire non volatile et pouvant supporter une tension de l'ordre de 10 V (par exemple une tension de programmation ou d'effacement), et
- des transistors à faible épaisseur d'oxyde de grille (transistors dits "logiques" i.e. permettant de réaliser la circuiterie logique).

Or, les transistors logiques présentent une bande passante élevée mais une faible tenue en tension, et les transistors haute tension présentent une faible bande passante : si la fréquence des signaux DT1, DT2 augmente, ils n'arrivent pas à "suivre" les variations signal et à transmettre les données (ils commutent trop lentement de l'état passant à l'état bloqué et vice-versa).

Ainsi, il peut se produire que les transistors conventionnels du circuit intégré ne permettent pas de réaliser un circuit tampon offrant les performances visées en termes de tenue en tension et de bande passante. Les concepteurs doivent alors prévoir des transistors spécifiques. Il s'ensuit une augmentation sensible du prix de revient du circuit intégré, car l'ajout d'un troisième type de transistor implique la prévision de diverses étapes supplémentaires dans le processus de fabrication du circuit intégré.

Les spécifications de la norme USB sont un exemple typique de cahier des charges pouvant être problématique. On sait réaliser des circuits tampons répondant aux spécifications USB "Full Speed" en utilisant des transistors haute tension conventionnels, car les spécifications USB "Full Speed" prévoient une fréquence de transfert de données assez faible, de l'ordre de 12 MHz (soit 12 Mb/s). Par contre, les spécifications USB "High Speed" prévoient une fréquence de transfert de données de 480 MHz (soit 480 Mbit/s) avec des signaux de données différentiels D+, D- pouvant être compris entre 400 et 800 mV (soit 400 mV de tension différentielle).

Plus particulièrement, les signaux différentiels D+, D- transmis sur un bus USB présentent des niveaux de tension de 0,0 à 0,3 V pour le niveau bas (0 logique) et de 2,8 à 3,6 volts pour le niveau haut (1 logique) en mode "Full Speed" (FS). En mode "High Speed" (HS), ces signaux varient de -10 à +10 mV pour le niveau bas et de 360 à 440 mV pour le niveau haut.

Les spécifications USB "High Speed" sont donc plus contraignantes que les spécifications "Full Speed" en termes de bande passante, mais moins contraignantes en terme de tenue en tension puisque les données sont véhiculées par des tensions plus faibles. Néanmoins, un circuit tampon USB prévu pour émettre des signaux en mode "High Speed" doit pouvoir résister à la tension maximale de 3,6 V prévue par les spécifications "Full Speed" car une transmission de données en mode "High Speed" doit d'abord être négociée en mode "Full Speed" avant de basculer dans le mode "High Speed". Des transistors haute tension conventionnels peuvent supporter une telle tension, mais ne permettent pas de réaliser un circuit tampon conforme aux spécifications USB "High Speed" car leur bande passante est trop faible.

La présente invention vise un circuit tampon présentant des performances supérieures au circuit tampon classique décrit ci-dessus, en termes de tenue en tension et de bande passante, à performances de transistors égales.

Des modes de réalisation de la présente invention concernent un circuit intégré sur plaquette de semi-conducteur, comprenant un premier circuit tampon de données connecté à une plage de contact, le circuit tampon comprenant un premier transistor et un second transistor en série ayant chacun une borne de conduction connectée à la plage de contact, un troisième transistor en série avec le premier transistor, et un quatrième transistor en série avec le second transistor, et des moyens pour appliquer une première tension de polarisation sur une borne de conduction du troisième transistor, une deuxième tension de polarisation sur une borne de conduction du quatrième transistor, une troisième tension de polarisation inférieure à la deuxième tension de polarisation sur une borne de contrôle du premier transistor, une quatrième tension de polarisation supérieure à la première tension de polarisation sur une borne de contrôle du second transistor, et un signal de données sur une borne de contrôle du troisième transistor et sur une borne de contrôle du quatrième transistor.

Selon un mode de réalisation, la première tension de polarisation est une tension d'alimentation interne du circuit intégré.

Selon un mode de réalisation, la deuxième tension de polarisation est un potentiel de masse du circuit intégré.

Selon un mode de réalisation, les premier et second transistors sont des transistors MOS à haute tenue en tension et les troisième et quatrième transistors sont des transistors MOS à large bande passante.

Selon un mode de réalisation, les troisième et quatrième transistors sont des transistors MOS présentant une première épaisseur d'oxyde de grille, les premier et second transistors sont des transistors MOS présentant une seconde épaisseur d'oxyde de grille supérieure à première épaisseur d'oxyde de grille.

Selon un mode de réalisation, le circuit intégré comprend au moins un circuit de contrôle comprenant des transistors MOS présentant une première épaisseur d'oxyde de grille, et une mémoire non volatile comprenant des transistors MOS présentant une seconde épaisseur d'oxyde de grille supérieure à la première épaisseur d'oxyde de grille ; les premier et second transistors du circuit tampon sont des transistors MOS présentant la seconde épaisseur d'oxyde de grille, et les troisième et quatrième transistors du circuit tampon sont des transistors MOS présentant la première épaisseur d'oxyde de grille.

Selon un mode de réalisation, le circuit intégré comprend des moyens survolteurs pour fournir la quatrième tension de polarisation.

Selon un mode de réalisation, le circuit intégré comprend des moyens non survolteurs pour fournir la quatrième tension de polarisation à partir d'une tension externe appliquée au circuit intégré.

Selon un mode de réalisation, le circuit intégré comprend des moyens survolteurs pour fournir la troisième tension de polarisation.

Selon un mode de réalisation, le circuit intégré comprend des moyens pour appliquer aux moyens survolteurs un signal de consigne déterminant l'amplitude de la tension de polarisation fournie par les moyens survolteurs, et des moyens pour mémoriser le signal de consigne.

Selon un mode de réalisation, le circuit intégré comprend un port USB, des plages de contact pour émettre des données, et un deuxième circuit tampon à quatre transistors, le premier circuit tampon étant relié à la première plage de contact USB, et le deuxième circuit tampon relié à la seconde plage de contact USB.

Selon un mode de réalisation, le circuit intégré comprend un troisième et un quatrième circuits tampons comprenant chacun un premier et un second transistors et reliés respectivement à la première plage de contact USB et à la seconde plage de contact USB, et un circuit de contrôle configuré pour désactiver les premier et second circuits tampons, activer les troisième et quatrième circuits tampons et initier une communication par l'intermédiaire des troisième et quatrième circuits tampons, puis désactiver les troisième et quatrième circuits tampons, activer les premier et deuxième circuits tampons, et continuer la communication par l'intermédiaire des premier et deuxième circuits tampons.

Selon un mode de réalisation, le circuit intégré comprend des moyens pour fournir au circuit tampon un signal de données comprenant deux signaux identiques.

Selon un mode de réalisation, le circuit intégré comprend un processeur sécurisé.

L'invention concerne également un dispositif portatif, notamment une carte à puce ou une carte SIM, comprenant un circuit intégré selon l'invention.

Des exemples de réalisation de circuits intégrés selon la présente invention seront maintenant décrits à titre non limitatif, en relation avec les figures jointes, parmi lesquelles :
- la figure 1 précédemment décrite représente schématiquement un circuit intégré comprenant un circuit tampon classique,
- la figure 2 représente schématiquement un mode de réalisation d'un circuit intégré comprenant un circuit tampon selon l'invention,
- les figures 3A et 3B illustrent la réponse en fréquence du circuit tampon de la figure 2 en fonction de l'amplitude d'une tension de polarisation qui lui est appliquée,
- la figure 4 représente une variante de réalisation du circuit intégré de la figure 2,
- la figure 5 représente schématiquement un mode de réalisation d'un circuit intégré comprenant un port USB et des circuits tampons selon l'invention,
- la figure 6 représente schématiquement un mode de réalisation d'un circuit intégré comprenant une pluralité de circuits tampons selon l'invention,
- la figure 7 représente schématiquement un objet portatif comprenant un circuit intégré selon l'invention.

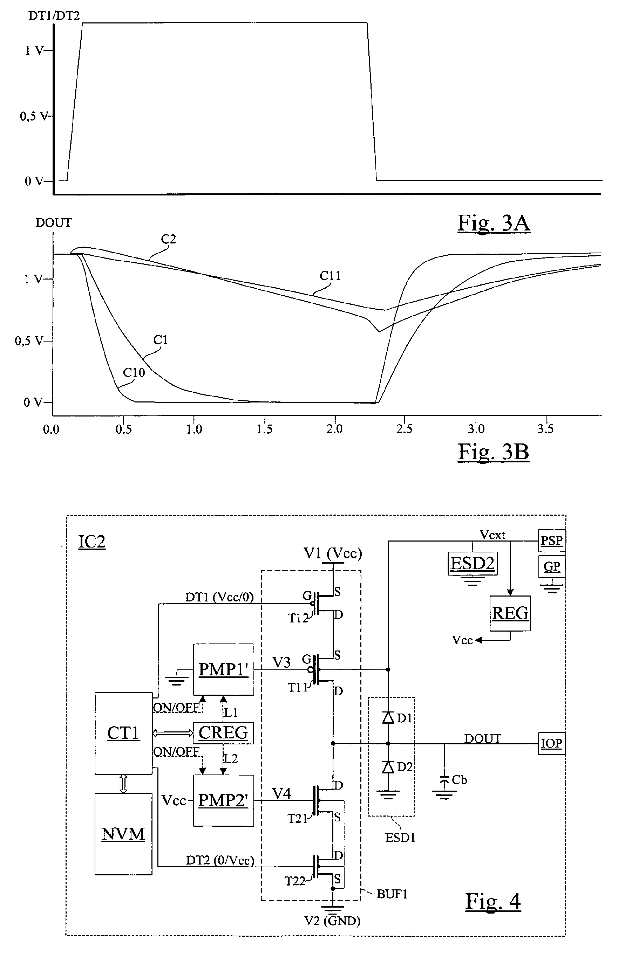

La figure 2 et les figures 4 à 6 représentent des circuits intégrés IC1, IC2, IC3, IC4 selon l'invention, réalisés au moyen de transistors MOS. Dans ce qui suit, on désignera par "source" et "drain" les bornes de conduction de source et de drain d'un transistor MOS et par "grille" la borne de contrôle de grille d'un tel transistor. Les bornes de source et de drain de transistors MOS sont repérées sur les figures 2 et 4 par les signes "S" et "D" et les bornes de contrôle de grille sont repérées par le signe "G".

Le circuit intégré IC1 représenté sur la figure 2 comprend un circuit tampon de données BUF1 selon l'invention. Le circuit intégré comprend également une plage de contact IOP, un circuit de contrôle CT1 et une mémoire non volatile NVM. Le circuit de contrôle CT1 est par exemple un microprocesseur, un microcontrôleur ou un séquenceur à logique câblée (machine d'états). Le circuit de contrôle CT1 fournit un signal de données DOUT à la plage de contact IOP par l'intermédiaire du circuit tampon BUF1. Le signal de données DOUT est appliqué au circuit tampon BUF1 sous la forme de deux signaux identiques DT1 et DT2 dont la polarité est inversée relativement au signal DOUT, le circuit tampon BUF1 fonctionnant en inverseur.

Le circuit tampon BUF1 comprend des transistors PMOS T11 et NMOS T21 d'un premier type et des transistors PMOS T12 et NMOS T22 d'un second type. Les transistors du premier type ont un oxyde de grille épais et présentent une bonne tenue en tension mais une faible bande passante. Les transistors du second type ont un oxyde de grille de faible épaisseur et présentent une large bande passante mais une faible tenue en tension.

La source du transistor T12 reçoit une tension de polarisation V1. Le drain du transistor T12 est connecté à la source du transistor T11. Le drain du transistor T11 est connecté au drain du transistor T21. Les drains des transistors T11 et T21 sont connectés à la plage IOP et fournissent le signal DOUT. La source du transistor T21 est connectée au drain du transistor T22. La source du transistor T22 reçoit une tension de polarisation V2 inférieure à la tension de polarisation V1. La tension V1 est par exemple une tension d'alimentation interne Vcc du circuit intégré et la tension V2 est par exemple une tension nulle, ou potentiel de masse (GND) du circuit intégré.

La grille du transistor T12 reçoit le signal DT1 et la grille du transistor T22 reçoit le signal DT2. Les signaux DT1, DT2 peuvent être des signaux analogiques dont la valeur en tension varie entre une tension minimale et une tension maximale, ou des signaux logiques qui présentent deux niveaux de tension correspondant au 1 et au 0 logiques, par exemple Vcc et 0 ou tous autres niveaux de tension aptes à provoquer un changement dans l'état de conductivité des transistors T12, T22 (état passant ou état bloqué).

Enfin, la grille du transistor T11 reçoit une tension de polarisation V3 et la grille du transistor T21 reçoit une tension de polarisation V4. La tension V3 est inférieure à la tension la plus basse qui polarise le circuit tampon, soit la tension V2. La tension V2 étant ici égale au potentiel de masse, la tension V3 est une tension négative. La tension V4 est supérieure à la tension la plus élevée qui polarise le circuit tampon, soit la tension V1. La tension V1 étant ici égale à Vcc, la tension V4 est une tension positive supérieure à Vcc.

La tension V3 est fournie par la sortie d'une pompe de charge négative PMP1 dont l'entrée est reliée à la masse. La tension de polarisation V4 est fournie par la sortie d'une pompe de charges positive PMP2 dont l'entrée reçoit la tension Vcc. Les pompes de charges PMP1, PMP2 sont contrôlées par le circuit CT1, qui les active ou les désactive au moyen de signaux ON/OFF.

Dans le mode de réalisation illustré sur la figure 2, le circuit intégré IC1 reçoit en outre une tension d'alimentation externe Vext, supérieure à Vcc, par l'intermédiaire d'une plage de contact d'alimentation PSP et d'une plage de contact de masse GP. La tension Vcc est fournie par un régulateur de tension REG recevant la tension Vext sur son entrée. Dans un tel mode de réalisation, la tension de polarisation V4 pourrait être générée à partir de la tension Vext sans utiliser la pompe de charge PMP2, par exemple au moyen d'un régulateur auxiliaire (non représenté). La tension V4 pourrait également être la tension Vext elle-même.

A titre d'exemple numérique, un mode de réalisation du circuit intégré IC1 peut présenter les paramètres suivants :
- Vext = 3,6 V ;
- V1 = Vcc = 1, 3 V ;
- V2 = 0 V ;
- V3 = - 2 V ;
- V4 = 3V ;
- Transistors T12, T22 :
   - Oxyde de grille : 2 à 3 nm ;
   - Largeur de canal : 90 nm ;
   - Tenue en tension : 1,3 V ;
- Transistors T11, T21 :
   - Oxyde de grille : 20 nm
   - Largeur de canal : selon besoin et spécifications ;
   - Tenue en tension : > 10V.

Le tableau 2 ci-après décrit le fonctionnement du circuit tampon BUF1 dans le cas ou V1=Vcc et V2=0 et où les signaux DT1, DT2 sont des signaux logiques. Comme indiqué plus haut, le signal de données DOUT fourni à la plage IOP est l'inverse des signaux logiques DT1, DT2. Le circuit tampon peut par ailleurs être placé dans un état de haute impédance (HZ), en appliquant aux transistors T11 et T21 des tensions de polarisation V3 et V4 respectivement égales à Vcc et à 0 (masse), de manière que les transistors T11, T21 soient bloqués.

**Tableau 2**

| **DT1 (T1)** | **DT2 (T2)** | **V3** | **V4** | **DOUT** |
|---|---|---|---|---|
| indifférent | indifférent | Vcc | 0 | HZ |
| 0 (GND) | 0 (GND) | négative (-2 v) | > Vcc (3 V) | 1 (Vcc) |
| 1 (Vcc) | 1 (Vcc) | négative (-2 v) | > Vcc (3V) | 0 (GND) |

Dans un mode de réalisation, le tampon BUF1 est configuré de manière à ce qu'il puisse résister, lorsqu'il est dans l'état bloqué (HZ), à une tension sur la plage IOP pouvant atteindre la valeur de la tension externe Vext. Dans ce cas, la tension Vext est appliquée au canal du transistor T11, comme représenté sur la figure 2, et la tension V3 est portée à Vext lorsque le tampon est placé dans l'état bloqué, comme décrit par le tableau 3 ci-dessous.

**Tableau 3**

| **DT1 (T1)** | **DT2 (T2)** | **V3** | **V4** | **DOUT** |
|---|---|---|---|---|
| indifférent | indifférent | Vext | 0 | HZ |
| 0 (GND) | 0 (GND) | négative (-2 v) | > Vcc (3 V) | 1 (Vcc) |
| 1 (Vcc) | 1 (Vcc) | négative > (-2 v) | > Vcc (3V) | 0 (GND) |

Dans encore une autre variante de réalisation, il peut être souhaité que le tampon BUF1 résiste à des décharges électrostatiques apparaissant sur la plage IOP. Dans ce cas, la plage IOP est équipée d'un circuit de protection ESD1. Le circuit ESD1 comprend par exemple une diode D1 reliant la plage IOP à la plage PSP, pour absorber les décharges de tension positive, et une diode D2 reliant la plage IOP à la masse, pour absorber les décharges de tension négative. La plage PSP, qui reçoit la tension Vext, est elle-même reliée à la masse par l'intermédiaire d'un circuit de protection ESD2.

Les figures 3A et 3B illustrent les performances du circuit tampon BUF1 en termes de bande passante, en fonction de la valeur des tensions de polarisation V3 et V4.

Plus particulièrement, la figure 3A représente les signaux DT1, DT2 passant de 0 à 1 et de 1 à 0, ce qui correspond à l'application d'un créneau de tension 0-Vcc-0 à l'entrée du circuit tampon (par exemple 0-1,3V-0). La figure 3B représente des courbes C1, C2, C10, C11 qui montrent la forme du signal DOUT à la sortie du circuit tampon. On suppose ici que la plage IOP est connectée à un bus de données ayant une capacité parasite non nulle, représentée par un condensateur Cb sur la figure 2, par exemple une capacité de l'ordre de 14 pF. On suppose également que les signaux DT1, DT2 varient à une fréquence élevée, par exemple la fréquence de 480 MHz prévue par les spécifications USB "High Speed", la durée de leur passage à 1 étant ainsi inférieure à 1,04 ns si leur rapport cyclique est égal à 0,5.

Les courbes C1 à C11 illustrent la réponse du circuit tampon dans quatre cas différents :
- la courbe C1 représente le signal DOUT lorsque les tensions V3, V4 sont égales à leur valeur nominale, par exemple V3=-2 V et V4=+3 V ;
- la courbe C2 est la forme du signal DOUT lorsque les tensions V3, V4 présentent des valeurs non survoltées, par exemple V3=0 V et V4=Vcc=1,3 V ;
- la courbe C10 illustre la réponse idéale d'un circuit tampon (ou la réponse du circuit tampon BUF1 obtenue à une fréquence plus faible) ;
- la courbe C11 représente le signal DOUT obtenu au moyen du circuit tampon classique CBUF (Cf. Fig. 1) réalisé avec des transistors T11, T21, dans les mêmes conditions de fonctionnement.

Il sera noté que les courbes C1, C2, C10, C11 n'ont qu'une valeur relative et ne sont données qu'à titre de comparaison. La forme précise de ces courbes dépend en pratique de la dimension des transistors utilisés, de l'épaisseur précise de leurs oxydes de grille et de divers autres paramètres technologiques comme la nature du substrat semi-conducteur, la composition de l'oxyde de grille utilisé, etc.

La courbe C1 montre que la réponse du tampon BUF1 est proche de l'idéal illustré par la courbe C10. En effet, la polarisation des grilles des transistors T11, T21 au moyen des tensions survoltées V3, V4 diminue le temps de réponse de ceux-ci et par conséquent augmente leur bande passante, qui est intrinsèquement faible en raison de l'épaisseur de leur oxyde de grille, comme le montre la courbe C11. Les transistors T11, T21 offrent également une bande passante plus étendue du fait qu'ils fonctionnement en tant que suiveurs tandis que les transistors T12, T21, qui présentent intrinsèquement une large bande passante en raison de leur faible épaisseur d'oxyde, fonctionnent en commutateurs. Les transistors T11, T21, qui sont connectés à la plage IOP, garantissent par ailleurs une bonne tenue en tension du tampon BUF1, l'épaisseur de leur oxyde de grille assurant une bonne résistance au claquage.

La courbe C11 montre que les mêmes transistors T11, T21 utilisés dans une structure de tampon classique CBUF (Fig. 1) ne peuvent pas "suivre" les signaux DT1, DT2, de sorte que le signal de sortie DOUT ne présente qu'une faible atténuation lorsque les signaux DT1, DT2 passent à 1, insuffisante pour caractériser le 0 logique.

La courbe C2 montre que le tampon BUF1 ne peut lui-même pas "suivre" les signaux DT1, DT2 lorsque les grilles des transistors T11, T21 sont polarisées avec des tensions V3, V4 non survoltées.

Ainsi, le circuit tampon BUF1 offre à la fois les performances élevées en termes de tenue en tension, grâce aux transistors T11, T21 à oxyde épais, et les performances élevées en termes de bande passante, grâce aux transistors à oxyde fin T12, T22 et à la polarisation des grilles des transistors T11, T21 au moyen des tensions V3, V4. Il est ainsi possible de réaliser un circuit tampon ayant des performances élevées dans un circuit intégré ne comprenant que ces deux types de transistors, sans qu'il soit nécessaire de prévoir un troisième type de transistor. Notamment, les transistors T12, T22 peuvent être des transistors du type utilisé pour réaliser le circuit CT1, tels des transistors logiques. Les transistors T11, T21 peuvent être du type utilisé pour réaliser la mémoire NVM.

Dans certaines conditions de fonctionnement, et notamment en présence d'inductances parasites, il peut se produire que le signal de sortie DOUT d'un circuit tampon conventionnel présente une ou plusieurs suroscillations après commutation, lorsque les signaux DT1, DT2 passent de 0 à 1 ou de 1 à 0, ce phénomène étant communément appelé "overshoot" ou "undershoot" par l'homme du métier. De telles suroscillations pourraient également apparaître en utilisant un circuit tampon selon l'invention. Dans ce cas, il pourrait être souhaité de réduire la bande passante du circuit tampon afin de diminuer voire de supprimer ce phénomène.

Le circuit intégré IC2 représenté sur la figure 4 permet à l'utilisateur de moduler la bande passante du circuit tampon, notamment pour maitriser le phénomène éventuel "d'overshoot" ou "d'undershoot". Le circuit intégré IC2 diffère du circuit intégré IC1 en que qu'il comporte des pompes de charges PMP1', PMP2' à niveaux ajustables, fournissant des tensions de polarisation V3, V4 dont la valeur est fonction de signaux de consigne L1, L2. Les signaux de consigne L1, L2 sont fournis par le circuit CT1 et sont mémorisés dans un registre de consigne CREG. Les valeurs des signaux L1, L2 peuvent être choisies par l'utilisateur par l'intermédiaire de commandes d'écriture du registre CREG, qui sont exécutées par le circuit CT1. L'utilisateur peut ainsi tester "in situ" différentes valeurs de signaux L1, L2, puis choisir celles qui conviennent le mieux à la fréquence de travail considérée et en fonction des paramètres de l'application, incluant les caractéristiques électriques du bus connecté à la plage IOP.

Un circuit tampon selon l'invention est susceptible de diverses applications, notamment pour réaliser des interfaces de bus rapides (au-delà de 80 Kb/s par exemple) pouvant supporter des tensions de bus élevées.

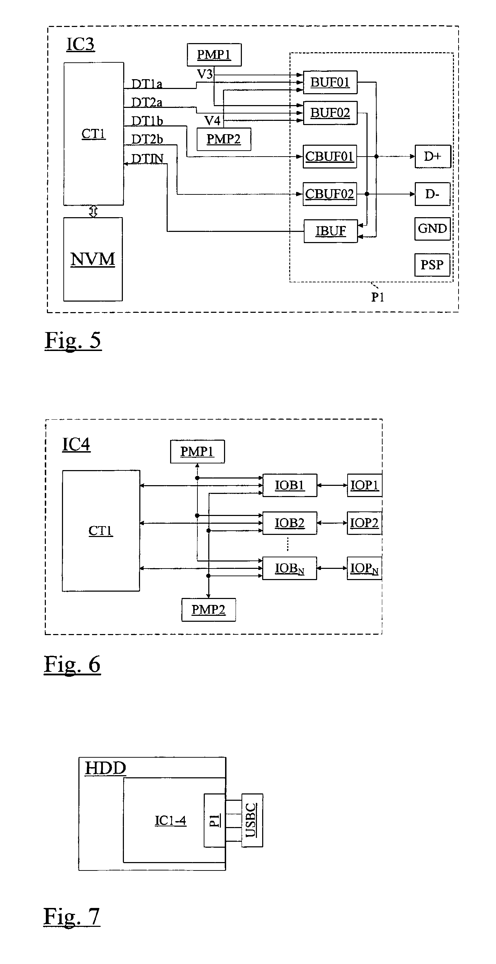

La figure 5 représente schématiquement un circuit intégré IC3 selon l'invention comprenant le circuit de contrôle CT1 et un port USB désigné P1. Le port P1 comprend une plage d'alimentation PSP, une plage de masse GND, une plage D+ une plage D-, des circuits tampons BUF01 et BUF02, des circuits tampons CBUF01, CBUF02, et un circuit IBUF de réception de données. La plage PSP reçoit ici une tension de 5 V qui peut être utilisée comme tension d'alimentation externe Vext du circuit intégré, la fourniture de la tension d'alimentation interne Vcc étant alors assurée par un régulateur de tension (non représenté). Les circuits tampons BUF01 et BUF02 sont de même structure que le circuit tampon BUF1 précédemment décrit (i.e. ils comportent quatre transistors) et sont polarisés par les tensions V3, V4 fournies par les pompes de charges PMP1, PMP2 (ou PMP1', PMP2'). Les circuits tampons CBUF01 et CBUF02 sont de type classique et sont par exemple de même structure que le tampon CBUF représenté sur la figure 1. Les tampons BUF01 et CBUF01 ont leurs sorties connectées à la plage D+. Les tampons BUF02 et CBUF02 ont leurs sorties connectées à la plage D-. Le circuit BUF01 reçoit un signal de données DT1a, le circuit CBUF01 reçoit un signal de données DT1b, le circuit BUF02 reçoit un signal de données DT2a, le circuit CBUF02 reçoit un signal de données DT2b. Les signaux DT1a, DT1b, DT2a, DT2b sont fournis par le circuit de contrôle CT1. Le circuit IBUF comporte une entrée différentielle connectée aux plages D+, D-, et est configuré pour lire des données entrantes DTIN appliquées sur les plages D+, D- et les fournir au circuit CT1.

Le circuit CT1 est configuré pour établir une communication USB en deux étapes .
- une étape de communication "Full Speed" où le circuit CT1 place les circuits tampons BUF01, BUF02 dans l'état bloqué de la manière décrite plus haut (Cf. tableau 2 ou 3) et où il active les tampons CBUF01, CBUF02. Dans ce cas, le circuit CT1 fournit les signaux DT1b, DT2b aux tampons CBUF01, CBUF02 lorsqu'il émet des données, et utilise le circuit IBUF pour recevoir des données DTIN. Au cours de cette première étape, le circuit CT1 communique avec un dispositif distant (non représenté) et négocie un basculement dans le mode "High Speed",
- une étape de communication "High Speed" avec le dispositif distant, où le circuit CT1 place les circuits tampons CBUF01, CBUF02 dans l'état bloqué de la manière décrite plus haut (Cf. tableau 1) et active les circuits tampons BUF01, BUF02. Dans ce cas le circuit CT1 fournit les signaux DT1a, DT2a aux tampons BUF01, BUF02 pour émettre des données, et utilise le circuit tampon IBUF pour recevoir des données.

La figure 6 représente un autre exemple de circuit intégré IC4 selon l'invention. Le circuit intégré IC4 comprend des plages de contact IOP1, IOP2,...IOP_{N}, chacune étant connectée à la sortie d'un circuit d'entrée/sortie IOBi (IOB1, IOB2,...IOB_{N}). Chaque circuit IOBi comprend un circuit tampon BUF1 du type précédemment décrit (non représenté) et un circuit de réception de données du type différentiel (par exemple IBUF, Fig. 5) ou non différentiel ("single ended"). Chaque circuit IOBi reçoit les tensions de polarisation V3, V4 fournies par les pompes de charge PMP1, PMP2 (ou PMP1', PMP2') et est relié au circuit de contrôle CT1 pour recevoir des données à émettre ou fournir des données reçues via la plage à laquelle il est connecté (ou reçues via les plages auxquelles il est connecté, en mode différentiel).

Un circuit intégré comprenant un ou plusieurs circuits tampons selon l'invention peut être un circuit intégré de carte SIM ("Subscriber Identification Module") équipée d'un port USB. Le circuit CT1 est dans ce cas un processeur sécurisé équipé de moyens de calcul cryptographique matériels (hardware) ou logiciels (software) pour conduire une procédure d'authentification du circuit intégré.

La figure 7 représente un dispositif portatif HDD ("Handheld Device") de type carte à puce, carte SIM, étiquette électronique, carte d'identité électronique, téléphone mobile, etc. Le dispositif HDD comprend un circuit intégré IC1-4 (IC1, IC2, IC3 ou IC4). Le circuit intégré IC1-4 comprend un port USB P1 du type décrit plus haut en relation avec la figure 5. Le dispositif HDD comprend un connecteur électrique USBC comprenant des contacts reliés aux plages de contact du port P1 du circuit intégré.

## Revendications

1. Circuit intégré (IC1-IC4) sur plaquette de semi-conducteur, comprenant un premier circuit tampon de données (BUF1, BUF01) connecté à une plage de contact (IOP, D+),
**caractérisé en ce que** le circuit tampon comprend :
- un premier transistor (T11) et un second transistor (T21) en série ayant chacun une borne de conduction connectée à la plage de contact,
- un troisième transistor (T12) en série avec le premier transistor (T11), et
- un quatrième transistor (T22) en série avec le second transistor (T21),
et **en ce qu'**il comprend des moyens (PMP1, PMP2) pour appliquer :
- une première tension de polarisation (V1, Vcc) sur une borne de conduction (S) du troisième transistor (T12),
- une deuxième tension de polarisation (V2, GND) sur une borne de conduction (S) du quatrième transistor (T22),
- une troisième tension de polarisation (V3) inférieure à la deuxième tension de polarisation (V2, GND) sur une borne de contrôle (G) du premier transistor (T11),
- une quatrième tension de polarisation (V4) supérieure à la première tension de polarisation (V1, Vcc) sur une borne de contrôle (G) du second transistor (T21), et
- un signal de données (DT1, DT2) sur une borne de contrôle (G) du troisième transistor (T12) et sur une borne de contrôle (G) du quatrième transistor (T22).

2. Circuit intégré selon la revendication 1, dans lequel la première tension de polarisation (V1, Vcc) est une tension d'alimentation interne du circuit intégré.

3. Circuit intégré selon l'une des revendications 1 et 2, dans lequel la deuxième tension de polarisation (V2, GND) est un potentiel de masse du circuit intégré.

4. Circuit intégré selon l'une des revendications 1 à 3, dans lequel les premier et second transistors (T11, T21) sont des transistors MOS à haute tenue en tension et les troisième et quatrième transistors (T12, T22) sont des transistors MOS à large bande passante.

5. Circuit intégré selon l'une des revendications 1 à 4, dans lequel les troisième et quatrième transistors (T12, T22) sont des transistors MOS présentant une première épaisseur d'oxyde de grille, les premier et second transistors (T11, T21) sont des transistors MOS présentant une seconde épaisseur d'oxyde de grille supérieure à première épaisseur d'oxyde de grille.

6. Circuit intégré selon l'une des revendications 1 à 5, comprenant :
- au moins un circuit de contrôle (CT1) comprenant des transistors MOS présentant une première épaisseur d'oxyde de grille, et
- une mémoire non volatile (NVM) comprenant des transistors MOS présentant une seconde épaisseur d'oxyde de grille supérieure à la première épaisseur d'oxyde de grille,
et dans lequel :
- les premier et second transistors (T11, T21) du circuit tampon sont des transistors MOS présentant la seconde épaisseur d'oxyde de grille, et
- les troisième et quatrième transistors (T12, T22) du circuit tampon sont des transistors MOS présentant la première épaisseur d'oxyde de grille.

7. Circuit intégré selon l'une des revendications 1 à 6, comprenant des moyens survolteurs (PMP2, PMP2') pour fournir la quatrième tension de polarisation (V4).

8. Circuit intégré selon l'une des revendications 1 à 6, comprenant des moyens non survolteurs pour fournir la quatrième tension de polarisation (V4) à partir d'une tension externe (Vext) appliquée au circuit intégré.

9. Circuit intégré selon l'une des revendications 1 à 8, comprenant des moyens survolteurs (PMP1, PMP1') pour fournir la troisième tension de polarisation (V3).

10. Circuit intégré selon la revendication 9, comprenant :
- des moyens (CREG) pour appliquer aux moyens survolteurs (PMP1', PMP2') un signal de consigne (L1, L2) déterminant l'amplitude de la tension de polarisation (V3, V4) fournie par les moyens survolteurs, et
- des moyens (CREG) pour mémoriser le signal de consigne (L1, L2).

11. Circuit intégré (IC3) selon l'une des revendications 1 à 10, comprenant un port USB (P1), des plages de contact (D+, D-) pour émettre des données, et un deuxième circuit tampon (BUF02) à quatre transistors, le premier circuit tampon (BUF01) étant relié à la première plage de contact USB (D+), et le deuxième circuit tampon (BUF02) relié à la seconde plage de contact USB (D-).

12. Circuit intégré selon la revendication 11, comprenant :
- un troisième (CBUF01) et un quatrième (CBUF02) circuits tampons comprenant chacun un premier et un second transistors et reliés respectivement à la première plage de contact USB (D+) et à la seconde plage de contact USB (D-), et
- un circuit de contrôle (CT1) configuré pour :
- désactiver les premier et second circuits tampons (BUF01, BUF02), activer les troisième et quatrième circuits tampons (CBUF01, CBUF02) et initier une communication par l'intermédiaire des troisième et quatrième circuits tampons, puis
- désactiver les troisième et quatrième circuits tampons (CBUF01, CBUF02), activer les premier et deuxième circuits tampons (BUF01, BUF02), et continuer la communication par l'intermédiaire des premier et deuxième circuits tampons.

13. Circuit intégré selon l'une des revendications 1 à 12, comprenant des moyens (CT) pour fournir au circuit tampon un signal de données comprenant deux signaux (DT1, DT2) identiques.

14. Circuit intégré selon l'une des revendications 1 à 13, comprenant un processeur sécurisé (CT1).

15. Dispositif portatif, notamment carte à puce ou carte SIM, comprenant un circuit intégré selon l'une des revendications 1 à 14.
